# EUROPÄISCHE PATENTANMELDUNG

(11) **EP 1 273 877 A2**
(43) Veröffentlichungstag der Anmeldung: **08.01.2003**
(21) Anmeldenummer: 02100722.4
(22) Anmeldetag: 19.06.2002
(51) Int. Cl.: G01B 11/00

(54) **Verfahren und Messvorrichtung zum Detektieren eines Objekts**

(30) Priorität: 04.07.2001 DE 10131897
(71) Anmelder: Leica Microsystems Semiconductor GmbH, 35578 Wetzlar (DE)
(72) Erfinder: Rinn, Klaus, Dr., 35452, Heuchelheim (DE)
(74) Vertreter: Reichert, Werner F., Dr.

(57) **Zusammenfassung**

Die vorliegende Erfindung betrifft ein Verfahren und eine Messvorrichtung zum Detektieren eines Objekts (1), wobei ein Objekt (1) mit einer Lichtquelle (2) beleuchtet, mit Hilfe einer Abbildungsoptik (3) auf einen vorzugsweise als CCD-Kamera ausgeführten Detektor (4) abgebildet und wobei das Objekt (1) mehrmals mit dem Detektor (4) detektiert wird. Mit dem erfindungsgemäßen Verfahren und der erfindungsgemäßen Messvorrichtung sind die Schwankungen der statistischen Auswertung von detektierten Signalen bzw. Daten minimierbar, wobei die detektierten Signale bzw. Daten detektionsbedingten Fehlerquellen unterliegen. Das erfindungsgemäße Verfahren und die erfindungsgemäße Messvorrichtung ist dadurch gekennzeichnet, dass dass die Detektionszeit des Detektors (4) bei den einzelnen Detektionen und/oder die Intensität des zur Objektbeleuchtung dienenden Lichts variiert wird.

## Beschreibung

Die vorliegende Erfindung betrifft ein Verfahren und eine Messvorrichtung zum Detektieren eines Objekts, wobei ein Objekt mit einer Lichtquelle beleuchtet, mit Hilfe einer Abbildungsoptik auf einen vorzugsweise als CCD-Kamera ausgeführten Detektor abgebildet und wobei das Objekt mehrmals mit dem Detektor detektiert wird.

Verfahren zur Detektion von Objekten der gattungsbildenden Art sind aus der Praxis bekannt. In industriellen Anwendungen, beispielsweise bei der Metrologie von Linienbreiten oder Positionen auf Substraten der Halbleiterindustrie, kommen Koordinaten-Messgeräte zum Einsatz, wie sie beispielsweise in der deutschen Patentanmeldung DE 198 19 492.7-52 beschrieben sind. Dieses Messgerät dient zur hochgenauen Messung der Koordinaten von Strukturen auf Substraten, z.B. Masken, Wafern, Flachbildschirmen und Aufdampfstrukturen, insbesondere aber für transparente Substrate. Die Koordinaten werden relativ zu einem Bezugspunkt auf wenige Nanometer genau bestimmt. Hierbei wird beispielsweise ein Objekt mit Licht einer Quecksilberdampflampe beleuchtet und mit Hilfe der Abbildungsoptik auf eine CCD-Kamera abgebildet. Die CCD-Kamera nimmt in aller Regel mehrere Bilder des gleichen Objekts mit gleicher Belichtungszeit auf. Die so gewonnenen Bilder werden einer statistischen Auswertung zugeführt. Die statistische Auswertung umfasst beispielsweise eine Mittelung der detektierten Bilddaten. Das so erhaltene Gesamtergebnis weist im Vergleich zur Auswertung eines einzelnen Bilds eine bessere Wiederholbarkeit auf.

Verfahren zum Detektieren eines Objekts, bei denen das Objekt mehrmals mit einem Detektor detektiert wird, können dann problematisch sein, wenn sich im Zeitraum der einzelnen Detektionen beispielsweise Veränderungen bei der Beleuchtungsintensität ergeben. Im Fall des Koordinaten-Messgeräts werden hauptsächlich Objekte detektiert, die definierte Objektstrukturen aufweisen, wobei die Objektstrukturen wiederum linienförmige Kanten aufweisen. Eine Aufgabe eines Koordinaten-Messgeräts ist unter anderem, die Lokalisation der Kanten der Objekte relativ zu einem Bezugspunkt so genau wie möglich zu bestimmen. Nach Detektion mehrerer Bilder des gleichen Objekts mit einer CCD-Kamera hat sich gezeigt, dass selbst bei geringen Schwankungen der Belichtungszeit der CCD-Kamera sich die Kantenlokalisation nach einer statistischer Auswertung der detektierten Bilddaten verändert hat. Dementsprechend wurde versucht, den Zielbereich der Belichtungsautomatik so eng wie möglich zu wählen, so dass bei den detektierten Bilddaten die Lokalisation der Kanten sich nicht ändert. Diese Vorgehensweise ist jedoch nicht für alle Bereiche des gleichen Objekts möglich, so dass ein gewisser Restfehler in der Kantenlokalisation bislang unvermeidbar ist. Darüber hinaus können der Veränderung der Detektion der Kantenlokalisation auch Restfehler zugrunde liegen, die nicht unmittelbar mit der Belichtungszeit der CCD-Kamera zusammenhängen. Diese Restfehler können systematischen oder zufälligen Ursprungs sein. Letztendlich ist angestrebt, sämtliche Restfehler und die damit verbundenen Veränderungen in der Datenauswertung zu minimieren.

Der vorliegenden Erfindung liegt daher die Aufgabe zugrunde, ein Verfahren zum Detektieren eines Objekts anzugeben und weiterzubilden, bei dem die Schwankungen der statistischen Auswertung von detektierten Signalen bzw. Daten minimiert werden, wobei die detektierten Signale bzw. Daten detektionsbedingten Fehlerquellen unterliegen.
Weiterhin liegt der vorliegenden Erfindung die Aufgabe zugrunde, eine Messvorrichtung zum Detektieren eines Objekts der gattungsbildenden Art derart anzugeben und weiterzubilden, bei dem die Schwankungen der statistischen Auswertung von detektierten Signalen bzw. Daten minimierbar sind, wobei die detektierten Signale bzw. Daten detektionsbedingten Fehlerquellen unterliegen.

Das erfindungsgemäße Verfahren der gattungsbildenden Art löst die voranstehende Aufgabe durch die Merkmale des Patentanspruchs 1. Danach ist ein solches Verfahren dadurch gekennzeichnet, dass die Detektionszeit des Detektors und/oder die Intensität des zur Objektbeleuchtung dienenden Lichts bei den einzelnen Detektionen variiert wird.

Erfindungsgemäß ist zunächst erkannt worden, dass äußere Einflüsse wie beispielsweise geringe Lichtintensitätschwankungen der Lichtquelle - wenn überhaupt - nur mit sehr hohem Aufwand verhindert werden können. Auch eine Optimierung der Detektionszeitautomatik, mit dem Ziel, bei jeder Objektdetektion die optimale Detektionszeit des Detektors einzustellen, kann nicht in allen Fällen fehlerfreie Ergebnisse liefern. Falls noch weitere zufällig oder systematisch bedingte Fehler der Objektdetektion zu minimieren sind, wird ebenfalls erfindungsgemäß nicht analysiert, welche Ursache den einzelnen Fehlern zugrunde liegt, um diese dann jeweils mit einer entsprechenden fehlerreduzierenden Maßnahme zu minimieren.

In erfindungsgemäßer Weise wird vielmehr die Detektionszeit des Detektors bei jeder einzelnen Detektion variiert. Durch die Variation der Detektionszeit wird zunächst einmal die Rauschbandbreite der Messergebnisse erhöht, denn es gehen die Einflüsse der unterschiedlichen Detektionszeiten in das Ergebnis ein. Die statistische Auswertung der gemessenen Daten mittelt aber über alle veränderlichen Fehlerkomponenten. Somit geht diesbezüglich nur der mittlere Fehler durch Detektionszeiteinflüsse im überstrichenen Detektionszeitintervall ins Messergebnis ein. Bei konstanter Detektionszeit geht jedoch der volle bzw. konstante Fehleranteil in die Detektion ein, welcher bei einer weiteren Detektion bzw. bei einer weiteren Detektionsserie mit geänderten Detektionsverhältnissen in Erscheinung tritt.

Somit ist in erfindungsgemäßer Weise keine Weiterentwicklung der Detektionszeitautomatik vorgesehen, die bei veränderten Umgebungsbedingungen das gleiche Detektionsergebnis erzielen soll, sondern die Detektionszeit des Detektors wird gezielt variiert, so dass die nachfolgende statistische Auswertung der detektierten Messdaten - weitgehend unabhängig von veränderten Umgebungsbedingungen - ein Ergebnis liefert, dass dem tatsächlichen, erwarteten Ergebnis am nächsten ist, wobei der Fehler aufgrund der Detektionszeitvariation minimiert wird.

Zusätzlich oder alternativ ist in erfindungsgemäßer Weise vorgesehen, die Intensität des zur Objektbeleuchtung dienenden Lichts bei jeder einzelnen Detektion zu variieren. Dies könnte beispielsweise mit einer im Beleuchtungsstrahlengang angeordneten, rotierenden Graufilterscheibe erfolgen.

Die Detektionszeitvariation und/oder die Intensitätsvariation des zur Objektbeleuchtung dienenden Lichts muss allerdings derart erfolgen, dass die Detektionssignale im Rahmen der zulässigen Detektoraussteuerung liegen, darf also nicht den Dynamikbereich des Detektors überschreiten. Dementsprechend ist in einem entsprechenden Verfahrensschritt vorgesehen, die Grenze der zulässigen Detektoraussteuerung im Rahmen einer Kalibrierung zu ermitteln. Eine Detektionszeitvariation ist dann nur innerhalb dieser Grenze sinnvoll. Für manche Applikationen könnte jedoch auch eine gezielte Übersteuerung bei einer Detektion vorgesehen sein, um beispielsweise Objektbereiche mit unterschiedlichen Intensitäten im niedrigen Dynamikbereich des Detektors darstellen zu können, wohingegen andere Objektbereiche Intensitäten liefern, die bei einer solchen Einstellung der Detektionszeit übersteuert detektiert werden.

Nun könnte die Detektionszeit- und/oder die Intensitätsvariation des zur Objektbeleuchtung dienenden Lichts systematisch oder zufällig erfolgen. Eine systematische Detektionszeitvariation könnte beispielsweise durch eine Erhöhung oder Verminderung der Detektionszeit von Detektion zu Detektion um einen konstanten Wert erfolgen. Weiterhin könnte die Detektionszeitvariation zufällig, beispielsweise mit Pseudozufallzahlen bzw. mit einem Random-Generator in Verbindung mit der Detektoransteuerung realisiert werden. Eine Variation der Detektionszeit könnte beispielsweise über die Detektoransteuerung erfolgen, insbesondere wenn diese mit einer das Gesamtsystem steuernden Einheit verbunden ist. So ist z.B. bei dem eingangs genannten Koordinaten-Messgerät die Variation der Detektionszeit, d.h. der Belichtungszeit der CCD-Kamera, durch eine entsprechende Ansteuerelektronik, der Camera-Timing-Control, realisiert.

Zur Variation der Intensität des zur Objektbeleuchtung dienenden Lichts könnte eine im Strahlengang angeordnete Graufilterscheibe dienen, die Bereiche unterschiedlicher Graufilterwerte aufweist, die vorzugsweise umfangsmäßig angeordnet sind. Die Graufilterscheibe könnte derart im Beleuchtungsstrahlengang angeordnet sein, dass durch deren Rotation die unterschiedlichen Bereiche auf den Beleuchtungsstrahlengang wirken und die Intensität des zur Objektbeleuchtung dienenden Lichts entsprechend variieren. Eine Variation der emittierten Lichtleistung der Lichtquelle ist ebenfalls denkbar.

Die detektierten Objektdaten werden in einem weiteren Verfahrensschritt einer statistischen Auswertung zugeführt. Hierbei ist im einfachsten Fall eine Mittelung der einzelnen Objektdetektionen vorgesehen, insbesondere dann, wenn Restfehler zu minimieren sind, die zufälligen Ursprungs sind. Eine andere statistische Gewichtung ist ebenfalls denkbar, wenn beispielsweise systematische Restfehler zu minimieren sind. Die statistische Auswertung umfasst auch Verfahrensschritte, die beispielsweise charakteristische Eigenschaften des detektierten Objekts bestimmen. So ist eine Bestimmung der Form sowie der Lokalisation des Objekts vorgesehen. Die Veränderung der charakteristischen Eigenschaften des detektierten Objekts wird in Abhänigkeit der Detektionszeitvariation bei der jeweiligen Detektion des Objekts bestimmt, so dass hieraus statistische Kenngrößen, wie beispielsweise Varianz und Standardabweichung der gemessenen charakteristischen Objekteigenschaften bestimmt werden können. Demgemäss wird der Einfluss der Variation der Detektionszeit auf die detektierten Objektdaten extrahiert.

In einem ganz besonders bevorzugten Verfahrensschritt wird eine zu detektierende Objekteigenschaft anhand einer Fitkurve bestimmt. Bei der Objekteigenschaft könnte es sich beispielsweise um charakteristische Objekteigenschaften wie die Objektlokalisation oder die Form des Objekts handeln. Die statistische Auswertung der detektierten Objektdaten sowie der Einfluss der Detektionszeitvariation auf die detektierten Objektdaten wird zur Bestimmung der Fitkurve herangezogen. So kann letztendlich das Ergebnis der detektierten Objekteigenschaft stets nach der gleichen Vorschrift bestimmt werden. Beispielsweise wird der Funktionswert der Fitkurve in der Mitte des Detektionszeitintervalls als Ergebnis einer statistischen Auswertung definiert.

In vorrichtungsmäßiger Hinsicht löst die erfindungsgemäße Messvorrichtung der gattungsbildenden Art die eingangs genannte Aufgabe durch die Merkmale des Patentanspruchs 9. Danach ist eine solche Messvorrichtung dadurch gekennzeichnet, dass die Detektionszeit des Detektors der einzelnen Detektionen und/oder die Intensität des zur Objektbeleuchtung dienenden Lichts variierbar ist.

Die erfindungsgemäße Messvorrichtung ist hierbei vorzugsweise derart ausgebildet, dass sie zur Durchführung eines Verfahrens nach einem der Ansprüche 1 bis 8 geeignet ist. Insbesondere ist hierbei der Detektor als CCD-Kamera ausgeführt. Insoweit wird zur Vermeidung von Wiederholungen auf den das Verfahren zum Detektieren eines Objekts entsprechenden Teil der Beschreibung verwiesen.

Es gibt nun verschiedene Möglichkeiten, die Lehre der vorliegenden Erfindung in vorteilhafter Weise auszugestalten und weiterzubilden. Dazu ist einerseits auf die den Patentansprüchen 1 und 9 nachgeordneten Patentansprüche und andererseits auf die nachfolgende Erläuterung eines bevorzugten Ausführungsbeispiels der Erfindung anhand der Zeichnung zu verweisen. In Verbindung mit der Erläuterung des bevorzugten Ausführungsbeispiels der Erfindung anhand der Zeichnung werden auch im Allgemeinen bevorzugte Ausgestaltungen und Weiterbildungen der Lehre erläutert. In der Zeichnung zeigen
- Fig. 1: eine schematische Darstellung einer erfindungsgemäßen Messvorrichtung zum Detektieren eines Objekts und
- Fig. 2: ein Diagramm, in dem gemessene Linienbreiten einer Struktur in Abhängigkeit unterschiedlicher Detektionszeiten aufgetragen sind.

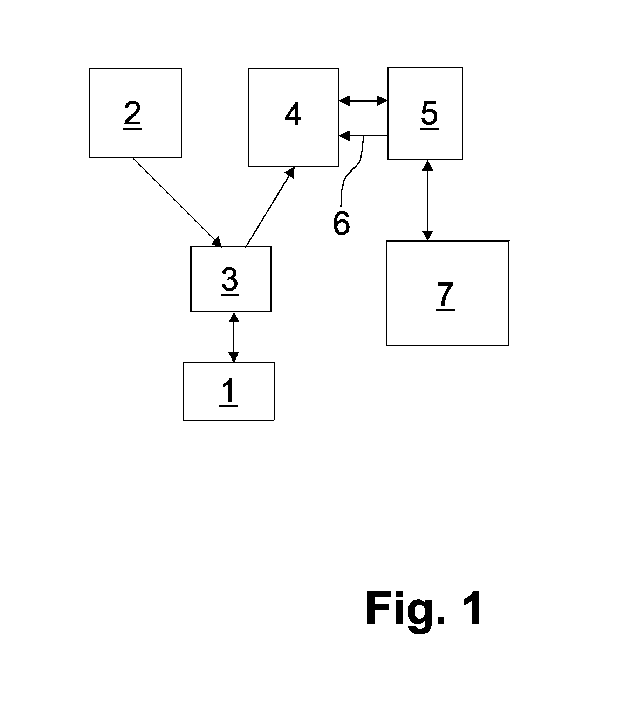

Fig. 1 zeigt schematisch eine als Koordinaten-Messgerät ausgeführte Messvorrichtung zum Detektieren eines Objekts 1. Das Objekt 1 wird mit einer Lichtquelle 2 beleuchtet. Eine Abbildungsoptik 3 bildet zumindest ein Teil des Objekts 1 auf einem Detektor 4 ab. Detektor 4 ist als CCD-Kamera ausgebildet. Das Objekt 1 wird mehrmals mit dem Detektor 4 detektiert bzw. aufgenommen.

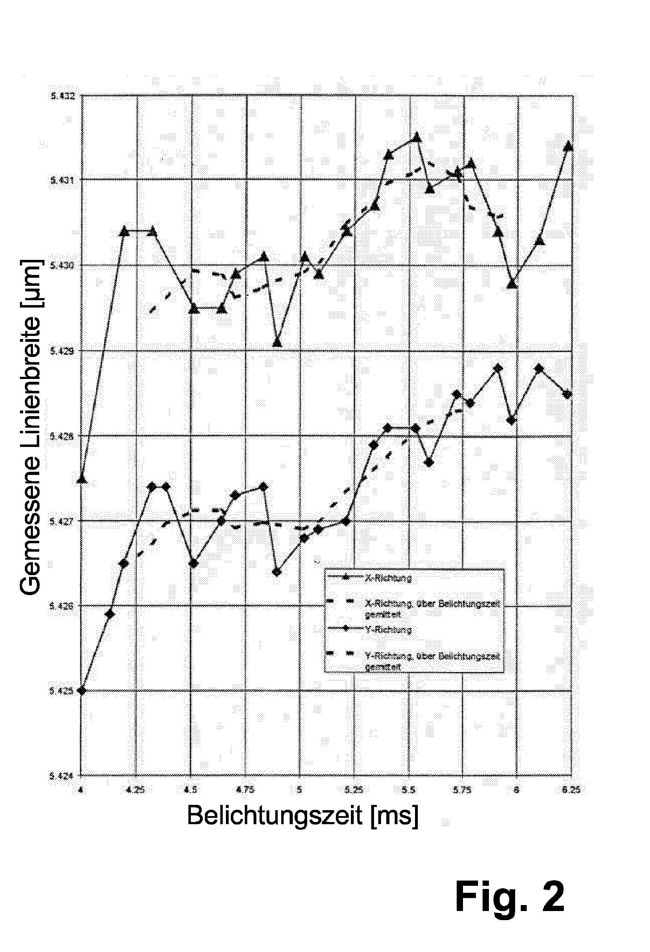

Bei dem Objekt 1 handelt es sich um eine zu vermessende Belichtungsmaske für die Waferbelichtung in der Halbleiterindustrie, wobei die Breite und die Lokalisation relativ zu einem Bezugspunkt einzelner dort vorgesehener Leiterstrukturen zu bestimmen sind. Das Diagramm aus Fig. 2 zeigt hierbei die gemessenen Linienbreiten in µm in Abhängigkeit der Belichtungszeit der CCD-Kamera, wobei die mit den Dreiecken gekennzeichneten Messwerte die Linienbreite in X-Richtung wiedergeben. Die mit den Vierecken gekennzeichneten Messwerte hingegen geben die gemessenen Linienbreiten in Y-Richtung der CCD-Kamera wieder. Die unterschiedlichen Belichtungszeiten sind in ms angegeben, wobei dem Diagramm entnommen werden kann, dass insbesondere bei den Belichtungszeiten von 4,5 ms, 4,9 ms, 5,6 ms und 5,97 ms unverhältnismäßig hohe Abweichungen der gemessenen Linienbreiten auftreten. Zur Verdeutlichung dieser Abweichungen sind de Messwerte in X bzw. Y-Richtung jeweils mit einer durchgezogenen Linie verbunden. Falls ein Objekt mit Belichtungszeiten in diesen kritischen Regionen detektiert wird, können selbst kleine Belichtungszeitvariationen die Linienbreite überproportional stark beeinflussen.

Erfindungsgemäß wird daher die Belichtungszeit der CCD-Kamera bei den einzelnen Detektionen variiert. Hierzu generiert die Detektoransteuerung 5 - d.h. die Camera-Timing-Control - mit einem Zufallsgenerator unterschiedliche Belichtungszeiten, die über die Ansteuerleitung 6 dem Detektor 4 in digitaler Form übermittelt wird. Die Belichtungszeit des Detektors 4 ist hierbei derart bemessen, dass sie im Rahmen der zulässigen Detektoraussteuerung liegt, so dass eine Überbelichtung des Detektors 4 vermieden wird.

Die vom Detektor 4 aufgenommenen Bilddaten des Objekts 1 werden einer statistischen Auswertung zugeführt, die auf dem Steuer- und Auswertungscomputer 7 der Messvorrichtung implementiert ist. Ein Ergebnis der statistischen Auswertung der gemessenen Linienbreiten bei unterschiedlichen Detektionszeiten sind die in Fig. 2 gestrichelt dargestellten Linien. Hierbei handelt es sich um gleitende Mittelwerte über fünf Belichtungszeiten. So kann diesem Linienverlauf entnommen werden, dass sich die Linienbreiten in Abhängigkeit der Belichtungszeit zwar ändern, jedoch keine hohen Abweichungen verglichen zu den ursprünglichen Messwerten auftreten.

Vorzugsweise wird daher der Einfluss der Belichtungszeitvariation auf die Linienbreite aus den detektierten Daten bestimmt und herausgerechnet. Das Ergebnis hierbei ist ein Verlauf der Linienbreite in Abhängigkeit von der jeweils eingestellten Belichtungszeit. Dieser Verlauf wird zur Hochrechnung der Linienbreite bei einer Detektion des Objekts mit konstanter Belichtungszeit benutzt. So könnte beispielsweise die Linienbreite in Abhängigkeit von der maximalen detektierten Helligkeit des Linienprofils durch eine Fitgerade approximiert werden. Diese Fitgerade könnte bei einer konstanten Helligkeit in der Mitte des Aussteuerungs- oder Belichtungszeitintervalls abgelesen werden.

Abschließend sei ganz besonders darauf hingewiesen, dass das voranstehend erörterte Ausführungsbeispiel lediglich zur Beschreibung der beanspruchten Lehre dient, diese jedoch nicht auf das Ausführungsbeispiel einschränken.

### Bezugszeichenliste

- 1: Objekt
- 2: Lichtquelle
- 3: Abbildungsoptik
- 4: Detektor
- 5: Detektoransteuerung
- 6: Ansteuerleitung
- 7: Steuer- und Auswertungscomputer

## Patentansprüche

1. Verfahren zum Detektieren eines Objekts (1), wobei ein Objekt (1) mit einer Lichtquelle (2) beleuchtet, mit Hilfe einer Abbildungsoptik (3) auf einen vorzugsweise als CCD-Kamera ausgeführten Detektor (4) abgebildet und wobei das Objekt (1) mehrmals mit dem Detektor (4) detektiert wird, **dadurch gekennzeichnet, dass** die Detektionszeit des Detektors (4) der einzelnen Detektionen und/oder die Intensität des zur Objektbeleuchtung dienenden Lichts variiert wird.

2. Verfahren nach Anspruch 1, **dadurch gekennzeichnet, dass** die Detektionszeitvariation und/oder die Intensitätsvariation des zur Objektbeleuchtung dienenden Lichts derart erfolgt, dass die Detektionssignale im Rahmen der zulässigen Detektoraussteuerung liegt.

3. Verfahren nach Anspruch 1 oder 2, **dadurch gekennzeichnet, dass** die Variation der Detektionszeit und/oder die Variation der Intensität des zur Objektbeleuchtung dienenden Lichts systematisch oder zufällig erfolgt.

4. Verfahren nach einem der Ansprüche 1 bis 3, **dadurch gekennzeichnet, dass** die Detektionszeit über die Detektoransteuerung variiert wird.

5. Verfahren nach einem der Ansprüche 1 bis 4, **dadurch gekennzeichnet, dass** die Intensität des zur Objektbeleuchtung dienenden Lichts durch eine im Strahlengang angeordnete, rotierende Graufilterscheibe variiert wird.

6. Verfahren nach einem der Ansprüche 1 bis 5, **dadurch gekennzeichnet, dass** die detektierten Objektdaten einer statistischen Auswertung zugeführt werden.

7. Verfahren nach einem der Ansprüche 1 bis 6, **dadurch gekennzeichnet, dass** der Einfluss der Variation der Detektionszeit auf die detektierten Objektdaten extrahiert wird.

8. Verfahren nach Anspruch 6 oder 7, **dadurch gekennzeichnet, dass** eine zu detektierende Objekteigenschaft, vorzugsweise die Objektlokalisation, anhand einer Fitkurve oder Fitfunktion, vorzugsweise einer Fitgerade, bestimmt wird.

9. Messvorrichtung zum Detektieren eines Objekts (1), vorzugsweise in Form eines Koordinaten-Messgeräts, mit einer ein Objekt (1) beleuchtenden Lichtquelle (2), mit einer Abbildungsoptik (3), die das Objekt (1) auf einen Detektor (4) abbildet und wobei das Objekt (1) mehrmals mit dem Detektor (4) detektierbar ist, vorzugsweise zur Durchführung eines Verfahrens nach einem der Ansprüche 1 bis 8,
**dadurch gekennzeichnet, dass** die Detektionszeit des Detektors (4) der einzelnen Detektionen und/oder die Intensität des zur Objektbeleuchtung dienenden Lichts variierbar ist.

10. Messvorrichtung nach Anspruch 9, **dadurch gekennzeichnet, dass** der Detektor als CCD-Kamera ausgeführt ist.
